# EUROPEAN PATENT APPLICATION

(11) **EP 1 426 462 A2**
(43) Date of publication of application: **09.06.2004**
(21) Application number: 03027352.8
(22) Date of filing: 27.11.2003
(51) Int. Cl.: C23C 14/24, C23C 14/04

(54) **Mask vapor deposition method and apparatus, mask, process for manufacturing display panel, display panel and electronic device**

(30) Priority: 03.12.2002 JP 2002350950
(71) Applicant: SEIKO EPSON CORPORATION, Shinjuku-ku, Tokyo 163-0811 (JP)
(72) Inventor: Atobe, Mitsuro, Suwa-shi Nagano-ken 392-8502 (JP); Yotsuya, Shinichi, Suwa-shi Nagano-ken 392-8502 (JP)
(74) Representative: Hoffmann, Eckart, Dipl.-Ing.

(57) **Abstract**

A method includes a step of attracting a glass substrate 20 that is a subject for deposition using the electrostatic attraction of a stage 1, a step of aligning the attracted glass substrate with a deposition mask 2, and a step of evaporating an organic compound that is a deposition material, used for forming electroluminescent elements so as to deposit the compound on the glass substrate 20. An electrostatic chucking function is provided to the deposition mask according to needs, whereby the adhesion is enhanced.

## Description

### Background of the Invention

### 1. Field of the Invention

The present invention relates to a mask vapor deposition method in which a masking operation is performed and vacuum deposition is then performed and also relates to a mask vapor deposition system, a mask used for vapor deposition and the like, an apparatus for manufacturing a display panel, a display panel, and an electronic device.

### 2. Description of the Related Art

Hitherto, a vapor deposition method has been used for forming thin-films on, for example, substrates using deposition materials. In the vapor deposition method, vapor deposition is performed in such a manner that a mask for vapor deposition (hereinafter referred to as a deposition mask) covers a surface so as to protect areas, on which thin-films or the like are not formed, against the vapor deposition. In this operation, the deposition mask must be placed so as not to be displaced. In particular, when color display panels including electroluminescent elements (hereinafter referred to as EL elements) containing inorganic or organic compounds are manufactured, precise alignment must be performed. This is because, for example, the deposited compounds directly emit light and therefore the compounds must be each deposited on corresponding predetermined areas in a precise manner depending on display colors so as not to disturb balance. Furthermore, the mask must have high definition. These requirements are important because the manufacture of large-sized panels is intended or the mass-production of panels is intended in such a manner that a plurality of small-sized panels are manufactured using large-sized substrates in one process.

For example, in a display panel including such EL elements, compounds for emitting light are deposited on a glass substrate, which is a subject for deposition. The glass substrate is warped due to film formation, ion implantation, and heat treatment for forming various thin-films such as TFDs (Thin Film Diodes) and TFTs (Thin Film transistors) in some cases. When the glass substrate is transferred in order to perform alignment, the center of the substrate sinks down due to gravity because ends of the substrate are gripped with holders or the like. An increase in size of the substrate renders this warp more serious. Since the deposition mask is usually aligned with the glass substrate using alignment marks placed on end portions having no bearing on the display panel, the fact that the warp is increased at the center means that the distance between the alignment marks placed on the deposition mask and the glass substrate is increased. Since the alignment is performed based on an obtained image, there is a problem in that an increase in distance therebetween causes defocusing. Therefore, the preciseness of the alignment is lowered and a great deal of time is involved in repeating the alignment. Thus, even if the mask has high definition, deposition cannot be performed with high preciseness and a great deal of time is spent. This problem is not characteristic of the glass substrate but is in common with other subjects for deposition.

In view of the above circumstances, the following method has been proposed: a mask that has a thickness of 0.05 mm and contains ferromagnetic metal is prepared so as to allow the mask to adhere to a warped glass substrate, and the mask is securely joined to the substrate by attracting the mask using a permanent magnet placed on the back face of the substrate while the mask follows the warp of the substrate (see, for example, Patent Document 1).

### [Patent Document 1]

Japanese Unexamined Patent Application Publication No. 10-41069 (page 5)

In the above method, the mask is aligned with the substrate and the resulting mask is then securely joined to the substrate by attracting the mask using the permanent magnet. Therefore, a misalignment between the mask and substrate is caused by shock due to the collision of the permanent magnet with the substrate in some cases.
Furthermore, the deposition mask is heated by radiant heat generated by heating a deposition material, whereby the mask is expanded in some cases. The deposition mask must contain metal (for example, nickel alloy or the like) attracted by a magnet in particular. When a subject for deposition is made of, for example, glass, there is a difference in thermal expansion coefficient in many cases. Therefore, the mask is warped or bent due to thermal stress, whereby the adhesion between the mask and the substrate is lowered and the mask is released from the substrate in some cases. Thus, the mask cannot be continuously used. When the adhesion is insufficient, the deposition material sticks onto shadow areas and is therefore deposited on the areas, on which the deposition material must not be deposited, in some cases. Thus, the above method is not fit for the manufacture of large-sized products and mass-production. Furthermore, processing accuracy in preparing metal masks is insufficient to prepare a high-definition mask for manufacturing panels including EL elements.

### Summary of the Invention

Accordingly, in order to solve the above problems, it is an object of the present invention to provide a mask vapor deposition method in which precise alignment can be achieved and the time can be reduced and which is fit for mass-production.

A mask vapor deposition method according to the present invention includes a step of attracting a subject for deposition using electrostatic attraction, a step of aligning the attracted deposition subject with a deposition mask, and a step of evaporating a deposition material to deposit the material on the deposition subject.
In the present invention, the deposition subject is attracted by electrostatic chucking or the like and retained while the warp is corrected, the attracted deposition subject is aligned with the deposition mask, and the deposition material is deposited on the deposition subject according to the pattern of the deposition mask. Thus, the warp of the deposition subject is corrected; hence, the adhesion of the deposition mask is increased, and the deposition material is prevented from sticking onto shadow areas during the vapor deposition, whereby the vapor deposition can be precisely performed. Furthermore, since an electrostatic chuck is used, the deposition mask can be prepared using a material such as silicon that is not attracted by a magnet. In the steps, since shock and the like are not generated after the completion of alignment, the vapor deposition can be performed while the precise alignment is maintained.

A mask vapor deposition method according to the present invention includes a step of aligning a subject for deposition with a vapor deposition mask having an electrostatic chucking function, a step of attracting the deposition subject to the deposition mask using electrostatic attraction, and a step of evaporating a deposition material to deposit the material on the deposition subject.

In the present invention, the vapor deposition mask has the electrostatic chucking function. The deposition mask is aligned with the deposition subject, the deposition subject is attracted by the electrostatic attraction and retained while the warp of the deposition subject is corrected, and the deposition material is then deposited. Since the deposition mask that can attract the deposition subject using the electrostatic chucking or the like is used, the adhesion between the deposition mask and the deposition subject can be greatly increased. Therefore, the deposition material is prevented from sticking onto shadow areas during the vapor deposition, whereby the vapor deposition can be precisely performed.

A mask vapor deposition system according to the present invention includes an electrostatic chucking mechanism for attracting a subject for deposition using electrostatic attraction; a deposition mask, brought into close contact with a face of the deposition subject, for depositing a deposition material in a predetermined pattern, the face being reverse to that of the deposition subject attracted by the electrostatic chucking mechanism; an evaporation source for evaporating the deposition material; and a vacuum chamber, wherein the mechanism, mask, and source are at least placed in the vacuum chamber.
In the present invention, in the vacuum chamber for performing vacuum deposition, the electrostatic chucking mechanism attracts the deposition subject using electrostatic attraction and retains the deposition subject while the warp is corrected, the deposition mask is brought into close contact with a face of the deposition subject which is reverse to a face attracted by the mechanism, and the deposition material is evaporated from the deposition source, thereby performing vapor deposition according to the pattern of the deposition mask. Thus, the warp of the deposition subject is corrected; hence, the adhesion of the deposition mask is increased, and the deposition material is prevented from sticking onto shadow areas during the vapor deposition, whereby the vapor deposition can be precisely performed. Furthermore, since an electrostatic chuck is used, the deposition mask can be prepared using a material such as silicon that is not attracted by a magnet. In the steps, since shock and the like are not generated after the completion of alignment, the vapor deposition can be performed while the precise alignment is maintained.

The mask vapor deposition system of the present invention further includes a ferromagnetic means for bringing the deposition subject into close contact with the deposition mask prepared using a magnetic material.
In the present invention, in order to increase the adhesion when the deposition mask is made of metal and is therefore attracted by magnetic force, the system further includes the ferromagnetic means such as an electromagnet. Thus, the adhesion between the deposition mask and deposition subject can be increased by the attraction.

A mask vapor deposition system according to the present invention includes a deposition mask for attracting a subject for deposition using electrostatic attraction and depositing a deposition material on the deposition subject in a predetermined pattern, an evaporation source for evaporating the deposition material, and a vacuum chamber, wherein the mask and source are at least placed in the vacuum chamber.
In the present invention, the deposition mask has an electrostatic chucking function. The deposition mask is aligned with the deposition subject, the deposition subject is attracted by electrostatic attraction and retained while the warp of the deposition subject is corrected, and the deposition material is evaporated from the deposition source, thereby performing vapor deposition according to a pattern. Thus, since the deposition mask that can attract the deposition subject using electrostatic chucking or the like is used, the adhesion between the deposition mask and the deposition subject can be greatly increased. Therefore, the deposition material is prevented from sticking onto shadow areas during the vapor deposition, whereby the vapor deposition can be precisely performed.

A process for manufacturing a deposition mask according to the present invention includes a step of forming an insulating layer on a semiconductor substrate; a step of providing a metal layer functioning as electrodes, on a predetermined portion of the insulating layer; a step of forming perforations for deposition in predetermined areas of the semiconductor substrate; and a step of further forming another insulating layer on the metal layer.
In the present invention, one insulating layer is formed on the semiconductor substrate and the metal layer functioning as electrodes for performing electrostatic chucking is then formed. After the perforations constituting a mask pattern are formed, the other insulating layer is formed in order to insulate the deposition mask from a subject for deposition. Thus, the perforations that are hardly deformed by heat can be formed with high precision by a precise processing method such as an etching method and the mask having high flatness can be obtained. The mask that can increase the adhesion of the deposition subject using electrostatic chucking can be manufactured.

A deposition mask according to the present invention includes a semiconductor substrate having perforations for deposition in predetermined areas of the substrate, wherein the deposition mask attracts a subject for deposition using electrostatic attraction by supplying electric charges.
In the present invention, the mask, which is not a metal mask, includes a semiconductor substrate made of, for example, gallium arsenic (GaAs) or the like and has perforations formed by an etching method according to the pattern of the deposition. The deposition mask of the present invention has an electrostatic chucking function and attracts the deposition subject using electrostatic attraction. Thus, the perforations that are hardly deformed by heat can be formed with high precision by a precise processing method such as an etching method and the mask having high flatness can be obtained. The adhesion between the deposition mask and deposition subject can be increased by electrostatic chucking.

A deposition mask according to the present invention includes a wired substrate and a single semiconductor substrate or a plurality of semiconductor substrates having perforations for deposition, in predetermined areas of the substrate, wherein the semiconductor substrate or semiconductor substrates are bonded to the wired substrate so as to function as electrodes for attracting a subject for deposition using electrostatic attraction.
In the present invention, the semiconductor substrate or semiconductor substrates having the perforations formed by, for example, an etching method according to the pattern of deposition are prepared and then bonded to the wired substrate. The semiconductor substrate or semiconductor substrates are used as masks and also used as electrodes. Thus, the perforations that are hardly deformed by heat can be formed with high precision by a precise processing method such as an etching method and the deposition mask having high flatness can be obtained. The adhesion between the deposition mask and deposition subject can be increased by electrostatic chucking.

In the deposition mask of the present invention, the semiconductor substrate or semiconductor substrates are made of silicon.
In the present invention, silicon (Si) is used as a material for the mask. Thus, the mask can be processed with high precision by an etching method or the like. Furthermore, when the mask has an electrostatic chucking function, the mask can be used as electrodes.

The deposition mask according to the present invention further includes electrodes having a positive or a negative polarity alternately arranged on the semiconductor substrate.
In the present invention, in order to provide an electrostatic chucking function to the mask, the positive and negative electrodes are alternately arranged on the semiconductor substrate. Thus, a bipolar electrostatic chuck can be achieved using the mask.

In the deposition mask according to the present invention, the electrodes are arranged so as to form an interdigital pattern.
In the present invention, the positive and negative electrodes are arranged so as to form an interdigital pattern densely. Thus, electrostatic attraction can be increased, thereby increasing the attracting force.

In the deposition mask of the present invention, a portion of the mask to be brought into contact with the subject for deposition is covered with silicon dioxide.
In the present invention, in order to insulate the mask from the deposition subject, the portion to be brought into contact with the deposition subject is covered with silicon dioxide. Thus, currents are prevented from leaking, the attracting force is maintained, and the deposition subject can be protected.

An apparatus for manufacturing a display panel according to the present invention includes an electrostatic chucking mechanism for attracting a glass substrate that is a subject for deposition using electrostatic attraction; a deposition mask to be brought into close contact with a face of the glass substrate in order to deposit an organic material, which is used for forming electroluminescent elements on the glass substrate in a predetermined pattern, the face being reverse to that of the glass substrate attracted by the electrostatic chucking mechanism; an evaporation source for evaporating the organic material; and a vacuum chamber, wherein the mechanism, mask, and source are at least placed in the vacuum chamber.
In the present invention, in the vacuum chamber for performing vacuum deposition, the electrostatic chucking mechanism attracts the deposition subject using electrostatic attraction and retains the deposition subject while the warp is corrected; the deposition mask is brought into close contact with a face of the deposition subject which is reverse to a face attracted by the mechanism; and the deposition material, used for forming electroluminescent elements, having, for example, low molecular weight is evaporated from the deposition source, thereby performing vapor deposition according to the pattern of the deposition mask. Thus, the warp of the deposition subject is corrected; hence, the adhesion of the deposition mask is increased, and the deposition material is prevented from sticking onto shadow areas during the vapor deposition, whereby the vapor deposition can be precisely performed. Furthermore, since an electrostatic chuck is used, the deposition mask can be prepared using a material such as silicon that is not attracted by a magnet. In the steps, since shock and the like are not generated after the completion of alignment, the vapor deposition can be performed while the precise alignment is maintained.

A display panel according to the present invention is manufactured by the above-mentioned display panel-manufacturing apparatus.
In the present invention, the display panel is manufactured by the display panel-manufacturing apparatus in which attractive retainment and precise alignment can be performed by the electrostatic chucking mechanism. Thus, the deposition material is prevented from sticking onto shadow areas during vapor deposition, and therefore the vapor deposition can be precisely performed, thereby obtaining the display panel having high definition.

An electronic device according to the present invention includes the above-mentioned display panel and has a display function.

In the present invention, the display panel is used for display sections of electronic devices such as mobile phones and digital cameras. Thus, the outside air can be prevented from entering. In particular, when electroluminescent elements are used, the electronic devices in which the light-emitting efficiency and the life are not deteriorated and the display sections have a long life can be obtained.

### Brief Description of the Drawings

FIG. 1 is an illustration showing a mask vapor deposition system according to a first embodiment.
FIG. 2 is a schematic view showing an deposition mask according to a second embodiment.
FIG. 3 is a sectional view taken along the line I-I of FIG. 2.
FIG. 4 is an illustration showing a process for preparing a mask pattern portion 11.
FIG. 5 is an illustration showing a process for preparing a mask holder 10.
FIG. 6 is an illustration showing an vapor deposition mask according to a third embodiment of the present invention.
FIG. 7 is an illustration showing a process for preparing a deposition mask 2B.
FIG. 8 is an illustration showing parts of a process for manufacturing a display panel including EL elements.
FIGS. 9A-9C are illustrations showing electronic devices according to a seventh embodiment.

### Description of the Preferred Embodiments

### First Embodiment

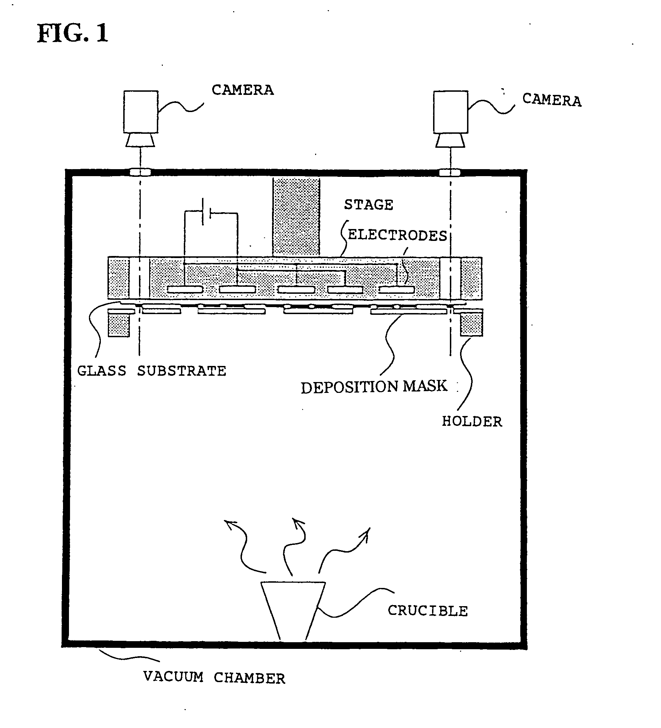

FIG. 1 is an illustration showing a mask vapor deposition system according to a first embodiment of the present invention. Mask vapor deposition is performed in a vacuum. Thus, a necessary mechanism, such as a transfer mechanism, which is not shown in FIG. 1, is placed in a vacuum chamber 50, wherein the mechanism is used for transferring a glass substrate 20 (that is a subject to be attracted, this embodiment uses the glass substrate 20 as an example, and the present invention is not limited thereto), which is a subject for deposition. An electrostatic chuck stage (hereinafter simply referred to as a stage) 1 is a flat table for attracting the glass substrate 20 by electrostatic chucking, correcting the warp, and preventing a deposition mask 2 that has been aligned from being misaligned thereafter. The electrostatic chucking is as follows: surfaces of the glass substrate 20 and stage 1 are positively or negatively charged by applying voltages to metal electrodes (hereinafter referred to as electrodes) 1A placed in the stage 1, and the glass substrate 20 is attracted and retained (hereinafter referred to as attractive retainment) by the Janssen-Rahbek force (also referred to as the Jhonsen-Rahbek force). The electrodes 1A placed in the stage 1 are arranged in such a manner that the electrodes 1A adjacent to each other have different polarities, and this arrangement is referred to as a bipolar type. There is another electrostatic chucking referred to as a unipolar type. In this type, the deposition subject must be grounded, and therefore the glass substrate 20 that is the deposition subject must be wired. In this embodiment, in view of mass production, the bipolar type is employed in order to avoid wiring the glass substrate 20. The stage 1 is turned with a turning mechanism (not shown). In order to align the deposition mask 2 with the glass substrate 20, the stage 1 can be transferred by the operation of a stepping motor (not shown).

The deposition mask 2 must be as flat as possible. A tension is preferably applied to the entire deposition mask 2 with a holder 30 for transferring the deposition mask 2. However, openings of a mask pattern must be prevented from being deformed. It is preferable to prepare the deposition mask 2 using a semiconductor substrate containing silicon or the like because such a substrate is superior in flatness.
The deposition mask 2 may be prepared using metal such as a nickel alloy. The deposition mask 2 has alignment marks, not shown in FIG. 1, used for the alignment with the glass substrate 20. The glass substrate 20 also has such alignment marks. In this embodiment, each of them has the two alignment marks in accordance with the number of cameras; however, the number of the marks is not limited to the above.

Cameras 3A and 3B include, for example, CCD cameras and are used for aligning the deposition mask 2 with the glass substrate 20. In this embodiment, part of the vacuum chamber 50 are transparent and perforations extend through parts of the stage 1, thereby taking pictures of parts of the glass substrate 20 through the perforations. Obtained images are displayed on a display means (not shown) placed out of the vacuum chamber 50. An operating person (operator) inputs data into an indicating unit (not shown) based on each image having the alignment marks placed on the glass substrate 20 and deposition mask 2, for alignment and then moves the stage 1 to perform alignment. Since the glass substrate 20 is transparent, the alignment marks placed on the deposition mask 2 can be displayed as an image. In this embodiment, the alignment is manually performed; however, the alignment may be automatically performed in such a manner that, for example, a processing means such as a computer or the like processes the obtained image to control the transfer of the stage 1. Furthermore, two pairs of marks are aligned using the two cameras 3A and 3B; however, the present invention is not limited to such a manner. Reference numeral 61 represents a crucible functioning as an evaporation source that evaporates a deposition material to be deposited on the glass substrate 20 by heating. In this embodiment, the single crucible 61 is placed at the center area of the vacuum chamber 50; however, the present invention is not limited to such a configuration. Crucibles may be arranged at a plurality of areas and various configurations may be employed.

A deposition procedure according to this vapor deposition method is described below. The glass substrate 20 is transferred to the stage 1 with the transfer mechanism. In this operation, the glass substrate 20 is transferred to such a position that the cameras 3A and 3B can take pictures of the alignment marks placed on the glass substrate 20. The electrodes 1A are then charged, whereby the glass substrate 20 is attractively retained to the stage 1 by the electrostatic chucking. In this attracting operation, the warp of the glass substrate 20 is corrected, whereby a gap between the glass substrate 20 and stage is eliminated.

The deposition mask 2 is brought as close as possible to the glass substrate 20 as long as the deposition mask 2 is not in contact with the glass substrate 20. In this embodiment, they are brought close to each other until the distance therebetween reaches, for example, 20 µm. The operator inputs data into the indicating unit, as described above, while the above situation is maintained, and then transfers the stage 1 to perform alignment. After the alignment is performed, the deposition mask 2 is further brought 20 µm close to the glass substrate 20, whereby the deposition mask 2 is allowed to come into close contact with the glass substrate 20. In this operation, the warp of the glass substrate 20 is corrected by the electrostatic chucking, thereby enhancing the adhesion to the deposition mask 2. Since the glass substrate 20 has been electrostatically chucked on the stage 1, the alignment can be precisely performed without generating shock. In this operation, although the warp of the glass substrate 20 is corrected with the stage 1, the adhesion between the glass substrate 20 and deposition mask 2 is lowered due to radiant heat or the like if the deposition mask 2 is made of metal or the like. In this case, a magnet may be placed on the side of the stage 1, whereby the deposition mask 2 is brought into close contact with the glass substrate 20 by magnetic force. A permanent magnet may be used, but an electromagnet is preferably used because the magnetic force can be controlled. Since the magnet is used for securely bringing the deposition mask 2 into close contact with the glass substrate 20 after the electrostatic chucking, shock is not generated after the alignment, in contrast to known methods.

Subsequently, the crucible 61 is heated, whereby the deposition material is vaporized and then vacuum-deposited on unmasked regions of the glass substrate. In this operation, the stage 1 is turned with the turning mechanism, whereby the deposition material is uniformly deposited over the regions of the glass substrate 20 for deposition. After the deposition is completed, the alignment is further performed and the deposition is repeated if other regions are subjected to the deposition. After all the deposition operations are finished, the deposition mask 2 is released from the glass substrate 20, the attractive retainment by the electrostatic chucking is ceased, and the glass substrate 20 is transferred from the stage 1 with the transfer mechanism.

As described above, according to the first embodiment, the glass substrate 20 is attractively retained on the stage 1 by the electrostatic chucking in advance, the warp of the glass substrate 20 is corrected, and the deposition material is deposited on the glass substrate 20 in such a manner that the deposition mask 2 is brought into close contact with the glass substrate 20. Therefore, the adhesion between the deposition mask 2 and the glass substrate 20, which is a subject for deposition, can be enhanced. Thus, the deposition material is prevented from sticking onto shadow areas, whereby the deposition can be precisely performed. Since the electrostatic chucking is employed, the deposition mask 2 can be prepared using a material that is not attracted by a magnet. Thus, a material, such as silicon, which has high processing accuracy and is hardly deformed, can be used. Even if the glass substrate 20 is large in size, the center area is not deformed by the attraction, whereby the alignment can be performed in a short time. In contrast to methods using permanent magnets, the attraction is not performed after the deposition subject is brought into close contact with the mask. Therefore, displacement is not caused by shock generated during the attraction, whereby the deposition can be performed while the precise alignment is maintained.

### Second Embodiment

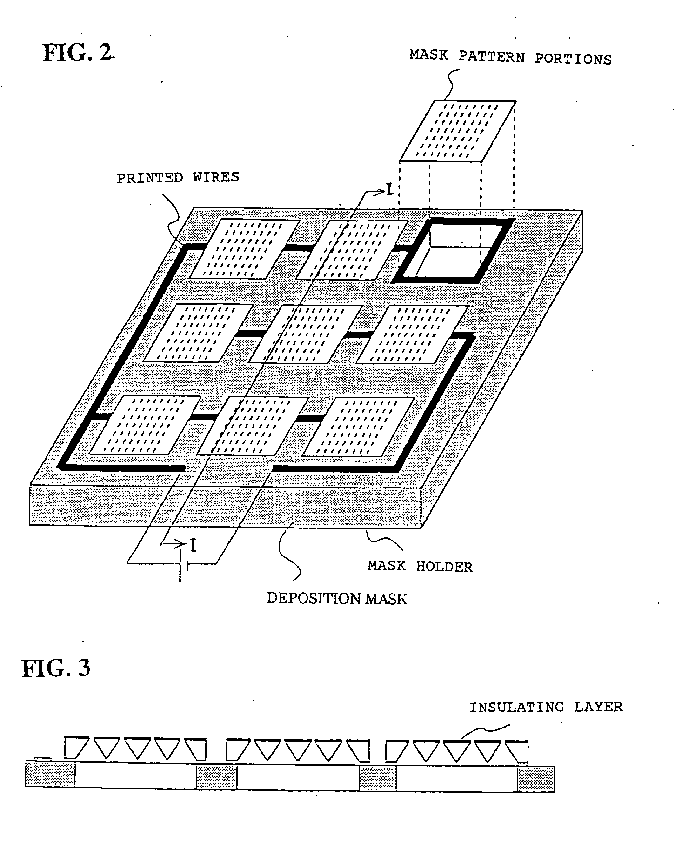

FIG. 2 is a schematic view showing an deposition mask 2A according to a second embodiment of the present invention. As shown in FIG. 2, the deposition mask 2A of this embodiment includes mask pattern portions 11 each comprising a silicon substrate and having high definition. The mask pattern portions 11 each function as an electrode and therefore the deposition mask has an electrostatic chucking function. The mask pattern portions 11 are each bonded to corresponding perforated regions of a mask holder 10 made of, for example, glass. The nine mask pattern portions 11 can be bonded to the mask holder 10 shown in FIG. 2. The mask holder 10 has printed wires 12 for supplying charges from a power source to the mask pattern portions 11 each functioning as an electrode. In this embodiment, the bipolar type is employed. In this case, the printed wires 12 are arranged such that the mask pattern portions 11 adjacent to each other have different polarities.

FIG. 3 is a sectional view taken along with the line I-I of the deposition mask 2A in FIG. 2. As shown in FIG. 3, a surface to be brought into contact with a subject for deposition is covered with an insulating layer 14 of, for example, silicon dioxide (hereinafter referred to as SiO₂) obtained by thermal oxidation. Therefore, a current is not directly applied to the deposition subject.

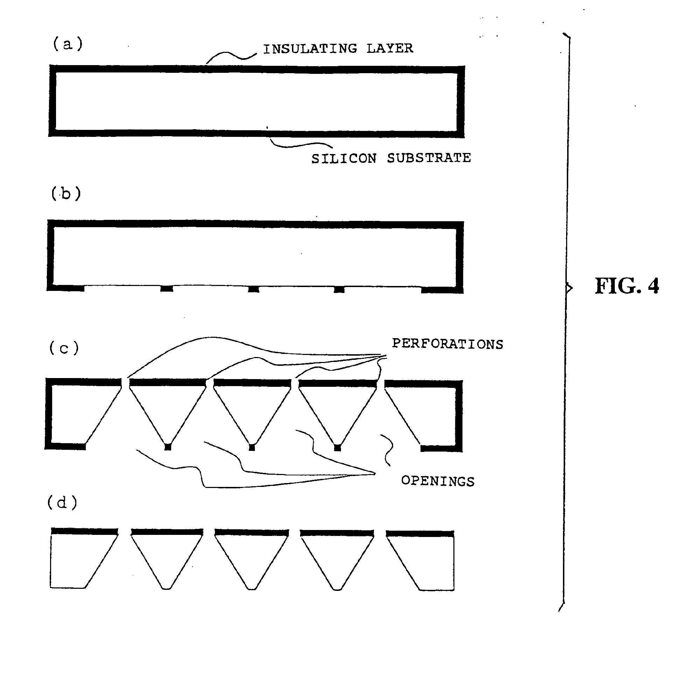

FIG. 4 is an illustration showing a process for preparing a mask pattern portion 11. A procedure of manufacturing the mask pattern portion 11 is described with reference to FIG. 4. Both faces of a silicon substrate 13 are planarized by polishing. The thickness of the silicon substrate 13 is not particularly limited; however, the silicon substrate 13 must have a thickness that is sufficient to endure attraction and sufficient to obtain high adhesion. The silicon substrate 13 is placed in a thermal oxidation furnace. The silicon substrate 13 is thermally oxidized at a predetermined temperature for a predetermined time in an atmosphere containing oxygen and steam. Thereby, the SiO₂ insulating layer 14 having a thickness of about 1 µm is formed on a surface of the silicon substrate 13 (FIG. 4(a)). In this step, the insulating layer 14 is formed by a thermal oxidation method; however, the insulating layer 14A may be formed by a CVD (Chemical vapor deposition) method or the like.

SiO₂ of the mask to be manufactured is patterned using a photomask by a photolithographic method. Thereby, a resist portion for SiO₂ is formed. That is, regions on which the resist portion is not disposed finally form openings. The insulating layer 14 is then etched with an etching solution containing fluoric acid (FIG. 4(b)). Thereby, SiO₂ remains at the resist portion. After the resist portion is etched, the silicon substrate 13 is soaked in an alkaline solution such as an aqueous potassium hydroxide (KOH) solution, thereby wet-etching unpatterned areas in the (111) crystal face in an anisotropic manner for a crystal. Thereby, openings 15 and tapered perforations 16 having a (111) crystal plane are formed (FIG. 4(c)). When wet-etching is performed in the (111) crystal, the etching proceeds at an angle of about 54.7°. The openings 15 on a wider side are made to face an evaporation source (downward) and the opening on a narrower side where the perforations 16 are formed, are made to face the deposition subject. Therefore, even if the evaporation source is only placed at the center, peripheral areas of the deposition subject are not covered with the mask pattern portions 11 and are subjected to deposition because the openings 15 are expanded downwards.

Subsequently, only SiO₂ remaining on the back face is removed (FIG. 4(d)). In a removing procedure, a dry film is stuck on the front face of the silicon substrate 13 and the resulting silicon substrate 13 is then soaked in BHF (a buffered hydrofluoric acid solution), thereby removing only the SiO₂ remaining on the back face. Thereby, the mask pattern portion 11 is prepared.

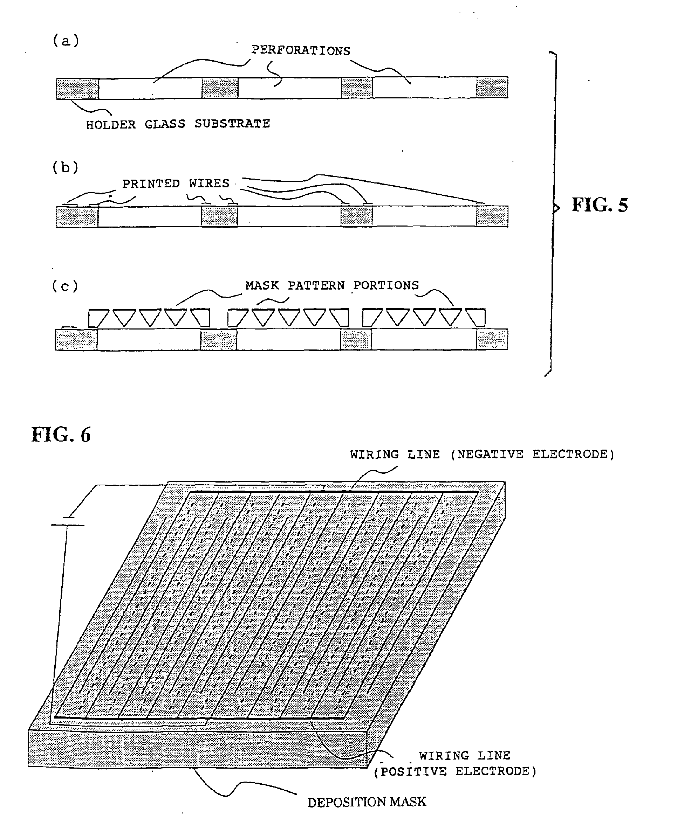

FIG. 5 is an illustration showing a process for preparing the mask holder 10. A procedure of preparing the mask holder 10 is described with reference to FIG. 5. Perforations 18 are formed in a holder glass substrate 17, which is a material for preparing the mask holder 10, in advance (FIG. 5(a)). A method for forming the perforations 18 includes, for example, a cutting method using a laser, a microblast machining method, and the like. The microblast is a machining technique of performing physical etching by applying abrasive grains.

A thin-film of Au/Cr (chromium-gold alloy) is formed on a face, to which the mask pattern portions 11 are to be bonded, by a sputtering method. Patterning is then performed by a photolithographic method, thereby allowing resist portions to remain on regions for forming the printed wires 12. Other regions having no resist portion are removed by an etching method, and the resist portions are then removed, thereby forming the printed wires 12 (FIG. 5(b)).

The prepared mask pattern portions 11 are stuck on the face (FIG. 5(c)). For the sticking, an adhesive is used. The adhesive contains conductive particles so as to connect the mask pattern portions 11 to the printed wires 12 electrically. The mask pattern portions 11 are pressed against the mask holder 10 and a pressure is applied thereto, thereby obtaining the deposition mask 2A.

As described above, according to the second embodiment, since the deposition mask has an electrostatic chucking function, the adhesion between the deposition mask and the deposition subject can be enhanced. Furthermore, since a shock is not applied to the deposition mask and the deposition subject that have been aligned with each other in the preparing steps, vapor deposition can be performed while precise alignment is maintained.

### Third Embodiment

FIG. 6 is an illustration showing an deposition mask 2B according to a third embodiment of the present invention. In the above-mentioned embodiment, the mask pattern portions 11 are stuck on the mask holder 10, thereby preparing a deposition mask. In this embodiment, a deposition mask is prepared using a single silicon wafer. For example, when a 12-inch wafer is used, a deposition mask with a side having a length of about 20 cm can be prepared. Au/Cr (chromium-gold alloy) is patterned on a silicon substrate, for forming wiring lines 19A and 19B and a voltage is then applied thereto, wherein the wiring line 19A functions as a positive electrode and the wiring line 19B functions as a negative electrode when charges are supplied from a power source. In this embodiment, wiring is performed so as to form an interdigital structure, thereby reducing the distance between the positive electrode and negative electrode. Thereby, the electrostatic attraction is increased and the Janssen-Rahbek force (attracting force) is increased.

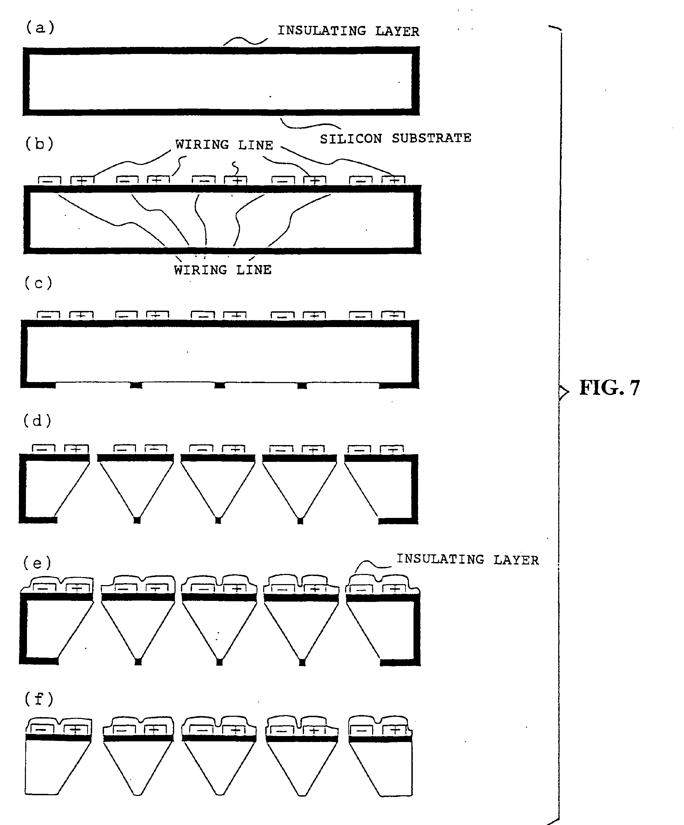

FIG. 7 is an illustration showing a process for preparing the deposition mask 2B. The process for preparing the deposition mask according to this embodiment is described below. Both faces of a silicon substrate 13A are planarized by polishing and the resulting silicon substrate 13A is placed in a thermal oxidation furnace in the same manner as that of preparing the mask pattern portions 11 in the above-mentioned second embodiment. The silicon substrate 13A is thermally oxidized at a predetermined temperature for a predetermined time in an atmosphere containing oxygen and steam, thereby forming an insulating layer 14A of SiO₂ (FIG. 7(a)). In this embodiment, the thermal oxidation is performed; however, the insulating layer 14A may be formed by a CVD method or the like.

A thin-film is formed by a sputtering method using Au/Cr (chromium-gold alloy). Patterning is performed by a photolithographic method so as to form an interdigital pattern, thereby providing resist portions on regions for forming wiring lines. Other regions having no resist portion are removed by an etching method, and the resist portions are then removed, thereby forming wiring lines 19A 19B of Au/Cr (FIG. 7(b)). The distance between the wiring lines is not limited to that shown in FIG. 7(b), and the wiring line 19A functioning as a positive electrode and the wiring line 19B functioning as a negative electrode are alternately arranged. The wiring lines have a height of about 2000-3000 angstroms (2 to 3 × 10⁻⁷ m). In order to increase the attracting force, the interdigital arrangement is preferable; however, the arrangement of the wiring lines is not limited to the interdigital arrangement.

After the wiring is completed, SiO₂ of the mask to be manufactured is patterned using a photomask by a photolithographic method, thereby forming resist portions for SiO₂. The insulating layer 14A is then etched with an etching solution containing fluoric acid (FIG. 7(c)). Thereby, SiO₂ remains at the resist portions. After the resist is removed, the silicon substrate 13A is soaked in an alkaline solution such as an aqueous potassium hydroxide (KOH) solution, thereby wet-etching unpatterned areas in the (111) crystal face in an anisotropic manner for a crystal (FIG. 7(d)).

After openings and perforations for forming a mask pattern are formed by wet-etching, an insulating layer 14B of SiO₂ is formed by a CVD method or the like in order to protect the interdigital wiring lines and insulate the wiring lines from a subject for deposition(FIG. 7(e)). Since the wiring lines of Au/Cr are arranged, a surface of the deposition mask 2B has irregularities in some cases. Since the wiring lines have a height of about 2000-3000 angstroms (2 to 3 × 10⁻⁷ m), the irregularities have such an order of magnitude. This order of magnitude is negligible as compared with the flatness of an deposition mask surface that is necessary in manufacturing organic EL panels. If higher flatness is necessary, the SiO₂ layer is polished by a CMP (Chemical-Mechanical Polishing) method or the like, thereby planarizing the surface of the deposition mask 2B. Only SiO₂ on the back face is then removed (FIG. 7(f)).

As described above, according to the third embodiment, since the deposition mask 2B is prepared using a single silicon substrate, the deposition mask having high flatness and high definition can be prepared. Since the wiring lines are placed on the silicon substrate and arranged in an interdigital pattern, and the positive and negative electrodes are alternately arranged, the electrostatic attraction is increased, thereby increasing the attracting force.

### Fourth Embodiment

In the above third embodiment, the deposition mask having the Au/Cr wiring lines arranged in an interdigital pattern is prepared. This can be applied to the mask pattern portions 11 of the second embodiment. In this case, as the mask pattern portions 11 each have a positive electrode and negative electrode, the wiring pattern of the mask becomes different from that of the printed wires 12 shown in FIG. 2.

### Fifth Embodiment

In the above embodiments, the prepared masks are used for vapor deposition. The present invention is not limited such a use and the masks may be used for processing such as sputtering or etching. A process for manufacturing a mask is not limited to the processes shown above and may include chemical or physical processing processes such as an etching process and sputtering process. Furthermore, there is a dry etching process such as reactive ion-etching process in addition to the wet-etching process and sputtering process.

### Sixth Embodiment

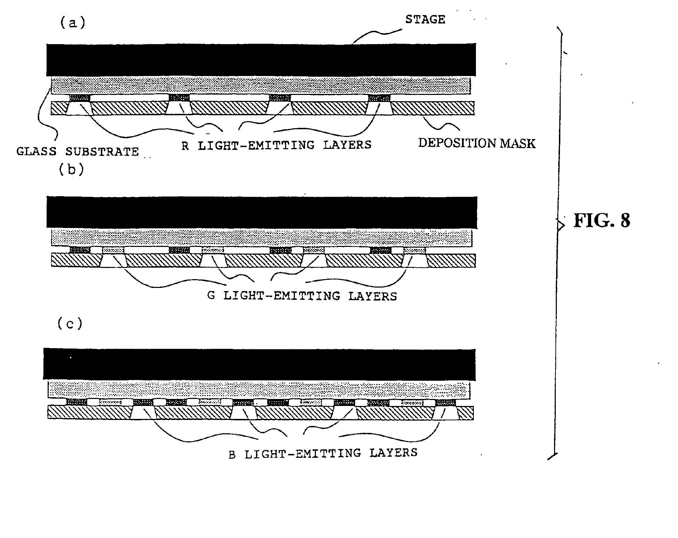

FIG. 8 is an illustration showing parts of a process for manufacturing a display panel including EL elements according to a sixth embodiment. In this embodiment, a process for manufacturing a color active matrix display panel including organic EL elements is described. In this embodiment, in order to obtain a full-color display panel, the following light-emitting substances are used as deposition materials: three light-emitting substances of corresponding organic compounds for emitting light rays of corresponding colors, for example, additive primary colors: R (red), G (green), and B (blue). The three light-emitting substances are deposited on a rectangular glass substrate 20 in such a manner that triplets of the light-emitting substances for each emitting corresponding R, G, and B light rays are repeatedly arranged in parallel to a side (usually a shorter side) of the glass substrate 20 at regular intervals. The arranged light-emitting substances must correspond to respective elements, which are TFTs disposed on the glass substrate 20.

A deposition mask 2C of this embodiment has a mask pattern corresponding to the above deposition. For example, openings are placed at the corresponding interval between the triplets (that is, for every triplet of three pixels) depending on the number of the triplets. The openings have a tapered shape, as described in the second embodiment. In order to deposit each light-emitting substance on respective predetermined regions, three alignment marks for the triplets are arranged in such a manner that the marks are displaced for each pixel. Three types of deposition masks are prepared, and vapor deposition may be performed while the deposition masks are changed. Before the glass substrate 20 is subjected to the steps shown in FIG. 8, the glass substrate 20 is subjected to a step of forming a transistor, a capacitor, wiring lines, a driving circuit, and the like for every pixel on the glass substrate 20 and a step of forming a transparent electrode for every pixel and then forming TFTs. Furthermore, the glass substrate 20 is subjected to a step of forming (layering) hole transport/injection layers on the transparent electrodes according to needs.

After these steps are performed, the glass substrate 20 is transferred into a vacuum chamber 50 and then attractively retained on a stage 1 or a deposition mask 2A by electrostatic chucking in the same manner as that of the first embodiment.
The deposition mask 2A and the glass substrate 20 are aligned at a position for depositing the R light-emitting substance and then brought into close contact with each other. In this step, when the stage 1 is not used and electrostatic chucking is performed using the deposition mask 2C, used in the second or third embodiment, having an electrostatic chucking function, the glass substrate 20 is brought into close contact with the deposition mask 2C and then electrostatically chucked by the mask so as to be attractively retained on the deposition mask 2C.

After the deposition mask 2C is brought into close contact with the glass substrate 20, the R light-emitting substance is deposited, thereby forming light-emitting layers functioning as cores of EL elements (FIG. 8(a)). The R light-emitting substance includes, for example, BSB-BCN. After the R light-emitting substance is deposited, the deposition mask 2C and the glass substrate 20 are aligned at a position (a position displaced for one pixel) for depositing the G light-emitting substance and then brought into close contact with each other. The G light-emitting substance is deposited, thereby forming light-emitting layers (FIG. 8(b)). Furthermore, in the same manner as that of the above, the deposition mask 2C and the glass substrate 20 are aligned at a position for depositing the B light-emitting substance with the position displaced further for one pixel and then brought into close contact with each other. The B light-emitting substance is deposited, thereby forming light-emitting layers (FIG. 8(c)).

After the light-emitting layers are formed by depositing the light-emitting substances, a step of forming cathode layers such as electron transport/injection layers or the like is performed according to needs, thereby manufacturing the active matrix display panel.

In this embodiment, the hole transport/injection layers, light-emitting layers, and electron transport/injection layers are separately formed. However the present invention is not limited to such a manner. The deposition mask 2C is brought into close contact with the glass substrate 20 and the hole transport/injection layers, light-emitting layers, and electron transport layers may be then formed by deposition. Alternatively, the following procedure may be performed: the electron transport layers are formed in advance and the light-emitting layers and hole transport/injection layers are then formed.

### Seventh Embodiment

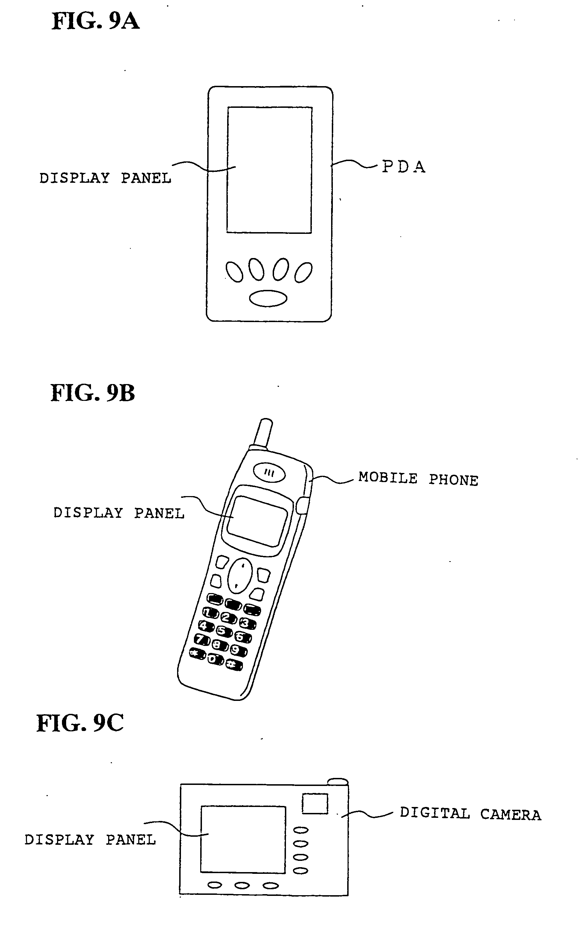

FIGS. 9A-9C is an illustration showing electronic devices according to a seventh embodiment of the present invention. FIG. 9A shows a PDA (Personal Digital Assistant), FIG. 9B shows a mobile phone, and FIG. 9C shows a digital camera. A display panel of the present invention can be used for such electronic devices, such as computers and game machines, having a display function and including a display panel, the devices being not shown in this embodiment.

### [Reference Numerals]

- 1:: stage
- 1A:: electrodes
- 2, 2A, 2B, and 2C:: deposition mask
- 3A and 3B:: cameras
- 10:: mask holder
- 11:: mask pattern portions
- 12:: printed wires
- 13 and 13A:: silicon substrate
- 14, 14A, and 14B:: insulating layer
- 15:: openings
- 16 and 18:: perforations
- 17:: holder glass substrate
- 19A and 19B:: wiring line
- 20:: glass substrate
- 30:: holder
- 50:: vacuum chamber
- 61:: crucible

## Claims

1. A mask vapor deposition method comprising:
a step of attracting a subject (20) for deposition using electrostatic attraction;
a step of aligning the attracted deposition subject (20) with a deposition mask (2); and
a step of evaporating a deposition material to deposit the material on the deposition subject (20).

2. A mask vapor deposition method comprising:
a step of aligning a subject (20) for deposition with a deposition mask (2A) having an electrostatic chucking function;
a step of attracting the deposition subject (20) to the deposition mask (2A, 2B) using electrostatic attraction; and
a step of evaporating a deposition material to deposit the material on the deposition subject (20).

3. A mask vapor deposition system comprising:
an electrostatic chucking mechanism (1) for attracting a subject (20) for deposition using electrostatic attraction;
an deposition mask (2), brought into close contact with a face of the deposition subject (20), for depositing a deposition material in a predetermined pattern, the face being reverse to that of the deposition subject (20) attracted by the electrostatic chucking mechanism (1);
an evaporation source (61) for evaporating the deposition material; and
a vacuum chamber (50),
wherein the mechanism, mask, and source are at least placed in the vacuum chamber.

4. The mask vapor deposition system according to Claim 3, further comprising a ferromagnetic means for bringing the deposition subject (20) into close contact with the deposition mask prepared using a magnetic material.

5. A mask vapor deposition system comprising:
a deposition mask for attracting a subject for deposition (20) using electrostatic attraction and depositing a deposition material on the deposition subject (20) in a predetermined pattern;
an evaporation source (61) for evaporating the deposition material; and
a vacuum chamber (50),
wherein the mask and source are at least placed in the vacuum chamber.

6. A process for manufacturing a deposition mask, comprising:
a step of forming an insulating layer (14A) on a semiconductor substrate (13A);
a step of providing a metal layer (19A, 19B) functioning as electrodes, on predetermined portions of the insulating layer (14A);
a step of forming perforations (16) for deposition, in predetermined areas of the semiconductor substrate (13A); and
a step of further forming another insulating layer (14B) on the metal layer (19A, 19B).

7. A deposition mask comprising a semiconductor substrate (13) having perforations (16) for deposition, in predetermined areas of the substrate, wherein the deposition mask attracts a subject (20) for deposition using electrostatic attraction by supplying electric charges.

8. A deposition mask comprising a wired substrate (10) and a single semiconductor substrate (11) or a plurality of semiconductor substrates (11) having perforations (18) for deposition, in predetermined areas thereof, wherein the semiconductor substrate or semiconductor substrates are bonded to the wired substrate so as to function as electrodes for attracting a subject (20) for deposition using electrostatic attraction.

9. The deposition mask according to Claim 7 or 8, wherein the semiconductor substrate or semiconductor substrates (11, 13) are made of silicon.

10. The deposition mask according to Claim 7 or 8, further comprising electrodes (19A, 19B) having a positive or a negative polarity alternately arranged on the semiconductor substrate (11, 13).

11. The deposition mask according to Claim 10, wherein the electrodes (19A, 19B) are arranged so as to form an interdigital pattern.

12. The deposition mask according to any one of Claims 7 to 11, wherein a portion of the mask to be brought into contact with the subject (20) for deposition is covered with silicon dioxide (14).

13. An apparatus for manufacturing a display panel, comprising:
an electrostatic chucking mechanism (1) for attracting a glass substrate that is a subject (20) for deposition using electrostatic attraction;
a deposition mask (2) to be brought into close contact with a face of the glass substrate (20) in order to deposit an organic material, which is used for forming electroluminescent elements on the glass substrate (20) in a predetermined pattern, the face being reverse to that of the glass substrate (20) attracted by the electrostatic chucking mechanism (1);
an evaporation source (61) for evaporating the organic material; and
a vacuum chamber (50),
wherein the mechanism, mask, and source are at least placed in the vacuum chamber.

14. A display panel manufactured by the display panel-manufacturing apparatus according to Claim 13.

15. An electronic device comprising the display panel according to Claim 14 and having a display function.
